# FASCICULE DE BREVET EUROPEEN

(11) **EP 0 789 246 B1**
(45) Date de publication et mention de la délivrance du brevet: **18.11.1998**
(21) Numéro de dépôt: 96470025.6
(22) Date de dépôt: 11.12.1996
(51) Int. Cl.: G01R 19/00, G01R 19/25

(54) **Circuit de mesure de courant**
Strommessschaltung
Current measuring circuit

(30) Priorité: 11.01.1996 FR 9600402
(43) Date de publication de la demande: 13.08.1997
(73) Titulaire: SGS-THOMSON MICROELECTRONICS S.A., 94250 Gentilly (FR)
(72) Inventeur: Le van Suu, Maurice, 57000 Metz (FR)
(74) Mandataire: Schmit, Christian Norbert Marie

(56) Documents cités:
- EP-A- 0 581 993

## Description

L'invention concerne un circuit de mesure de courant. Ce circuit peut être utilisé dans des systèmes nécessitant une mesure de courant. Son utilisation étant particulièrement recommandé dans les boucles de contre réaction de commande de moteur, les disjoncteurs électroniques ou les limiteurs de puissance qui ont besoin de valeurs précises.

Plusieurs circuits sont connus de l'homme du métier en ce qui concerne la mesure du courant. Beaucoup de circuits connus ont la particularité d'utiliser un convertisseur courant/tension pour pouvoir traiter l'information relative au courant de manière plus simple. L'élément le plus couramment utilisé pour une telle conversion est une résistance de shunt. Une telle résistance est insérée dans le circuit de manière à être traversée par le courant que l'on désire mesurer. Cette résistance doit être dimensionnée afin de perturber au minimum le circuit dans lequel elle est insérée. Un premier problème provient du choix de cette résistance qui doit être suffisamment élevée pour faire une mesure correcte et suffisamment faible pour ne pas perturber le circuit. De plus une certaine précision est exigée pour cette résistance, en général inférieure à 1 % d'erreur. Les résistances disponibles sur le marché offrent un large éventail de choix, néanmoins la résistance que l'on cherche n'existe pas toujours ou alors à un prix élevé.

A titre d'exemple, pour un disjoncteur électronique de carte d'ordinateur, la tension d'alimentation peut varier entre 4,7 V et 5,3 V. A 4,5 V la carte ne fonctionne plus normalement, et on désire limiter la consommation de la carte à 3 A. Il est possible de disposer d'une chute de tension de 0,2 V pour le disjoncteur. Cette chute de tension comprend la chute dans la résistance et la chute dans le transistor du disjoncteur. Il faudra donc choisir une résistance d'environ 0,025 ohms à moins de 1% d'erreur. Une telle résistance est en général utilisée pour des montages de plus forte puissance. Le choix se porte sur une résistance surdimensionnée et qui coûte relativement cher.

Pour des utilisations à fort courant, la chute de tension autorisée est plus importante. Pour une commande de moteur à courant continu, on a un courant de 100 A à mesurer en ayant une chute de moins de 2 V. Là encore on utilise une résistance capable de dissiper 200 W tout en étant précise sur sa valeur, le prix de cette résistance sera relativement élevé.

D'autres montages moins couteux sont également utilisés. Ces montages utilisent des composants non linéaires tel que des semi-conducteurs ou des transformateurs d'intensité. Cependant l'utilisation de tels composants entraîne un taux d'erreur plus important dû en général à la dispersion des composants ou à leur caractéristique. En effet, pour les semi-conducteurs, les différentes valeurs données peuvent avoir des variations de l'ordre de 20% (par exemple une résistance de diode peut être donnée comme étant comprise entre 0,4 et 0,5 ohms en valeurs extrêmes). Il est cependant possible de rendre ces montages plus précis en utilisant des circuits de compensation de la dispersion des composants nécessitant un temps de réglage coûteux.

Le document EP-A-0 581 993 dévoile un circuit de mesure utilisant des éléments non linéaires.

L'invention a pour but de réaliser un circuit de mesure de courant avec une précision inférieure à celle des composants en remédiant aux inconvénients des montages cités précédemment. La nouveauté de l'invention réside dans l'utilisation d'un processeur à logique floue avec un élément non linéaire de type semi-conducteur.

L'invention a pour objet un circuit de mesure du courant dans une charge, le dit circuit comportant un élément non linéaire de transformation de courant en une tension, caractérisé en ce qu'il comporte un processeur à logique floue pour traiter une mesure de ladite tension et fournir une information représentative du courant.

L'imprécision de l'élément non linéaire est en fait corrigé par le processeur à logique floue qui effectue une approximation linéaire d'une caractéristique de transfert courant tension de l'élément non linéaire. L'utilisation du processeur à logique floue permet de régler le circuit par apprentissage de manière rapide et donc peu coûteuse, en mémorisant des seuils de tension réels correspondant à des seuils de fonctions d'appartenance de type triangulaire. Le fait de mémoriser, dans une mémoire non volatile, des seuils de tensions réels permet de corriger de manière précise toutes les dispersions qui peuvent être dues à l'élément non linéaire. Une amélioration vise à utiliser également des fonctions d'appartenance de type gaussiennes.

L'invention propose d'utiliser différents semi-conducteurs comme élément non-linéaire car ils ont peu de dérive dans le temps. Ainsi l'élément non-linéaire peut être constitué de diodes, de transistors MOS ou bipolaires, de thyristors, ou de triacs. L'utilisation d'un élément actif permet d'effectuer la mesure du courant sur un élément déjà existant dans le circuit et de ce fait supprime les chutes de tension dues à l'ajout d'une sonde résistive.

L'invention sera mieux comprise et d'autres avantages apparaîtront au vu de la description qui va suivre, à lire conjointement aux dessins annexés et parmi lesquels:
- la figure 1 représente un mode de réalisation de l'invention utilisant une diode,
- la figure 2 représente la caractéristique d'une diode,
- la figure 3 représente une modélisation possible, suivant l'invention, de la caractéristique d'une diode,
- la figure 4 représente les fonctions d'appartenance associées à la modélisation de la figure 3,
- la figure 5 représente une autre possibilité de modélisation de caractéristique de diode suivant l'invention,
- la figure 6 représente les fonctions d'appartenance associées à la modélisation de la figure 5,
- la figure 7 représente un mode de réalisation de l'invention utilisant deux diodes,
- les figures 8 à 15 représentent différents modes de réalisation de l'invention utilisant des transistors bipolaires et des transistors MOS,
- la figure 16 représente un mode de réalisation de l'invention utilisant un thyristor,
- la figure 17 représente schématiquement un thyristor modifié selon l'invention,
- la figure 18 représente un mode de réalisation de l'invention utilisant un triac,
- la figure 19 représente schématiquement un triac modifié selon l'invention,
- les figures 20 et 21 représentent des modes de réalisation utilisant des matrices de triacs et des matrices de thyristor,
- la figure 22 représente schématiquement un processeur à logique floue tel que nécessaire dans l'invention.

Avant de décrire les différentes réalisations de l'invention, il est bon de rappeler le fonctionnement d'un processeur à logique floue. Un processeur à logique floue est un élément qui prend des décisions en fonction d'une ou plusieurs entrées (pour effectuer une mesure de courant, on n'utilise qu'une seule entrée) . Pour l'invention, les entrées utilisées sont de type analogique. Pour chaque variable d'entrée, il existe plusieurs fonctions d'appartenance qui servent à déterminer la proximité du niveau d'entrée par rapport aux différents seuils. Les différents seuils ainsi que les fonctions d'appartenance sont programmables. Les variables d'entrées sont de type analogique et peuvent être comprises entre +V et -V, V étant la tension d'alimentation du processeur à logique floue.

Pour chaque fonction d'appartenance, il existe au moins une règle qui établi une décision. Une valeur d'entrée pouvant appartenir à plusieurs fonctions d'appartenance, la décision qui est fournie est équivalente à une moyenne des décisions possibles pondérée par les fonctions d'appartenance. Les règles et les décisions sont également programmables.

Dans l'invention, l'utilisation d'un processeur à logique floue revient en fait à réaliser une approximation linéaire de la (ou des) variable(s) d'entrée. La précision dépendra en fait des fonctions d'appartenance associées à chaque entrée. Pour l'étalonnage d'un dispositif à logique flou, il suffit de placer les entrées à différents niveaux et d'enregistrer ces valeurs comme étant des seuils à associer aux fonctions d'appartenance. Autrement dit, pour une mesure de courant utilisant un élément non linéaire, la caractéristique de l'élément non-linéaire va déterminer le nombre de fonctions d'appartenance et leur répartition par rapport à ladite caractéristique. L'établissement des régles se fera en fonction de certaines valeurs correspondant à des points particuliers des fonctions d'appartenance. Les seuils des fonctions d'appartenance seront enregistrés dans une phase d'apprentissage qui est effectuée après montage de l'appareil. Le fait de recourir à une méthode d'apprentissage permet d'éliminer les différentes dispersions de caractéristique dues aux éléments non linéaires. Cela revient à compenser toutes les variations de caractéristique des éléments non linéaires.

L'apprentissage ne nécessite pas la présence d'un opérateur. Il peut se faire sur un banc de test automatisé. Le banc de test remplace la charge du circuit et positionne différentes valeurs de courant devant correspondre à certains seuils. Lorsque le courant est bien stable, le banc de test génère un signal d'enregistrement de seuil.

Une telle méthode peut également être utilisée pour recalibrer un appareil ayant subit certaines variations de caractéristique dues au vieillissement des composants.

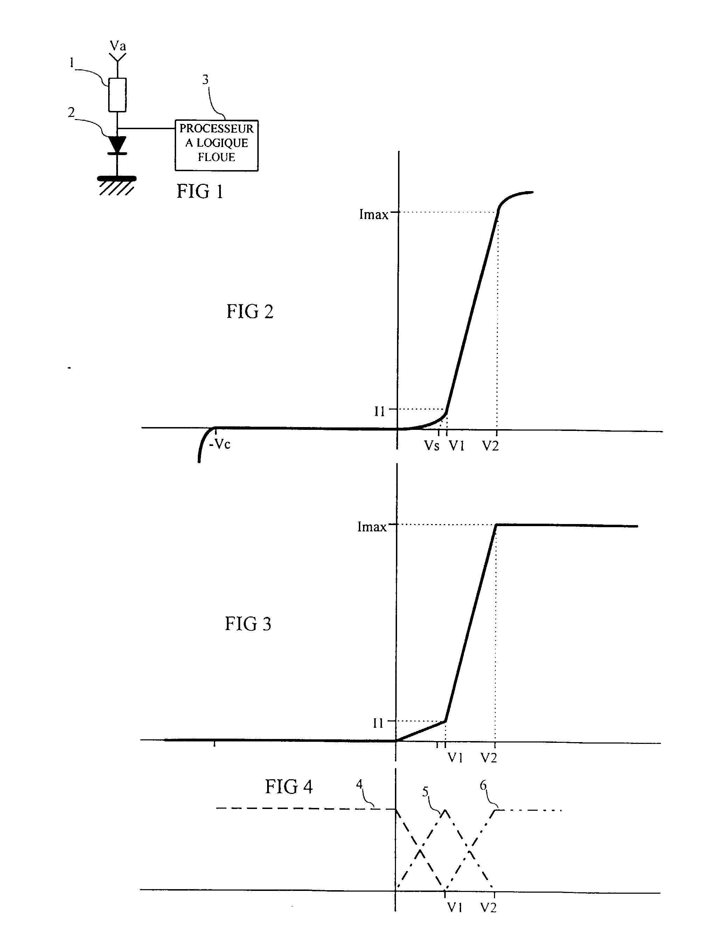

A titre d'exemple détaillé pour l'utilisation du processeur à logique floue, on utilise une réalisation de l'invention utilisant une diode, représentée sur la figure 1. Une charge 1 a une première borne reliée à une tension d'alimentation Va et une deuxième borne reliée à l'anode d'une diode 2, la cathode de cette diode 2 étant reliée à la masse. La tension aux bornes de la diode est représentative du courant qui la traverse, la correspondance se faisant par l'intermédiaire de la caractéristique de cette diode. Ainsi une entrée du processeur à logique floue 3 est connectée à l'anode de la diode 2. L'homme de métier comprend que la charge 2 peut être de différents types et qu'il est également possible de rajouter des éléments de protection à l'entrée du processeur à logique floue 3.

La figure 2 représente la caractéristique d'une diode. Cette caractéristique, bien connu dans la technique, est décomposable en cinq domaines de fonctionnement:
- un premier domaine non linéaire pour des tensions inférieures à -Vc (respectivement des courants inférieurs à 0 A),
- un deuxième domaine dit linéaire pour des tensions comprises entre -Vc et 0 V (respectivement des courants nuls),
- un troisième domaine non linéaire pour des tensions comprises entre 0 V et V1 (respectivement des courants compris entre 0 A et I1),
- un quatrième domaine dit linéaire pour des tensions comprises entre V1 et V2 (respectivement des courants compris entre I1 et Imax),
- un cinquième domaine non linéaire pour des tensions supérieures à V2 (respectivement des courants supérieurs à Imax).

Le premier domaine correspond au claquage de la diode qui peut être destructeur si la diode n'est pas prévue pour cela. Pour ne pas se trouver dans un tel cas, on choisit une diode avec un Vc (tension de claquage en inverse donnée par le constructeur) tel que le cas ne puisse pas se présenter.

Le deuxième domaine correspond à une diode bloquée, le courant est un courant de fuite quasiment nul.

Le troisième domaine correspond à la commutation de la diode. Une approximation de ce domaine est une exponentielle.

Le quatrième domaine correspond à une diode passante. Ce domaine est très proche d'une droite et le constructeur donne la tension de seuil Vs qui correspond à la tension du modèle de Thévenin de la diode ainsi que la résistance de la diode qui va donner la pente de la droite. Classiquement le constructeur donne les valeurs typiques et extrêmes de ces deux paramètres ce qui correspond suivant les diodes à une erreur de 5 à 20%.

Le cinquième domaine correspond à une dissipation de puissance dans la diode trop élevée qui va entraîner une destruction de la diode. En général, les constructeurs donne une valeur de courant maximal Imax avec un coefficient de sécurité.

Dans la pratique, les diodes sont utilisées avec des tensions supérieures à -Vc et avec des courants inférieurs à Imax. Pour notre exemple, on suppose que les courants qui nous intéressent sont compris entre 0 A et Imax. Ainsi, une modélisation comme celle de la figure 3 convient parfaitement pour une mesure très précise dans les deuxième et quatrième domaines et un peu moins précise dans le troisième domaine. Pour cela on utilisera les fonctions d'appartenance 4, 5 et 6 représentées sur la figure 4.

La première fonction d'appartenance 4 vaut "1" pour toutes les tensions inférieures ou égales à 0 V, décroît linéairement jusqu'à "0" pour une tension égale à V1, et vaut "0" pour les tensions supérieures à V1. La deuxième fonction d'appartenance 5 vaut "0" pour les tensions inférieures à 0 V ou supérieures à V2, croit linéairement de "0" à "1" pour des tensions allant de 0V à V1, et décroît linéairement de "1" à "0" pour des tensions allant de V1 à V2. La troisième fonction d'appartenance vaut "0" pour les tensions inférieures à V1, croit linéairement de "0" à "1" pour les tensions allant de V1 à V2, et vaut 1 pour les tensions supérieures à V2.

Le processeur à logique floue dispose de trois règles, une pour chaque fonction d'appartenance:
- si la tension mesurée appartient à la première fonction d'appartenance, alors le courant est égal à 0 A,
- si la tension mesurée appartient à la deuxième fonction d'appartenance, alors le courant est égal à I1,
- si la tension mesurée appartient à la troisième fonction d'appartenance, alors le courant est égal à Imax.

Dans cet exemple, trois seuils ont été pris. Le premier seuil correspondant à 0 V est indépendant de la diode; il sera donc fixé lors de la programmation des fonctions d'appartenance et des règles de décision. Les seuils V1 et V2 sont fixés sur banc d'essais. Sur le banc d'essais, il suffit de substituer à la charge 1 une charge variable muni de moyens d'étalonnage permettant de fixer les courants I1 et Imax. Lorsque chacun des courants est bien établi, on enregistre dans la mémoire du processeur flou la valeur de tension correspondante.

A titre d'exemple numérique, on désire mesurer avec précision un courant variant de 0,1 A à 20 A. On enregistre la valeur de tension correspondant à 0,1 A par exemple 0,8 V et la valeur de tension correspondant à 20 A, par exemple 2 V. Une mesure de tension de 1,5 V appartiendra à 58,3% à la troisième fonction d'appartenance, à 41,7% à la deuxième fonction d'appartenance et à 0% à la première fonction d'appartenance. On a donc le courant mesuré égal à 0,583 * 20 + 0,417 * 0,1 = 11,7 A.

Si l'homme de métier désire utiliser de manière plus précise la caractéristique de la diode dans le troisième domaine, il est préférable de rajouter des seuils, des fonctions d'appartenance et des règles de décision supplémentaires afin d'avoir une meilleur approximation de la courbe et donc une meilleure précision.

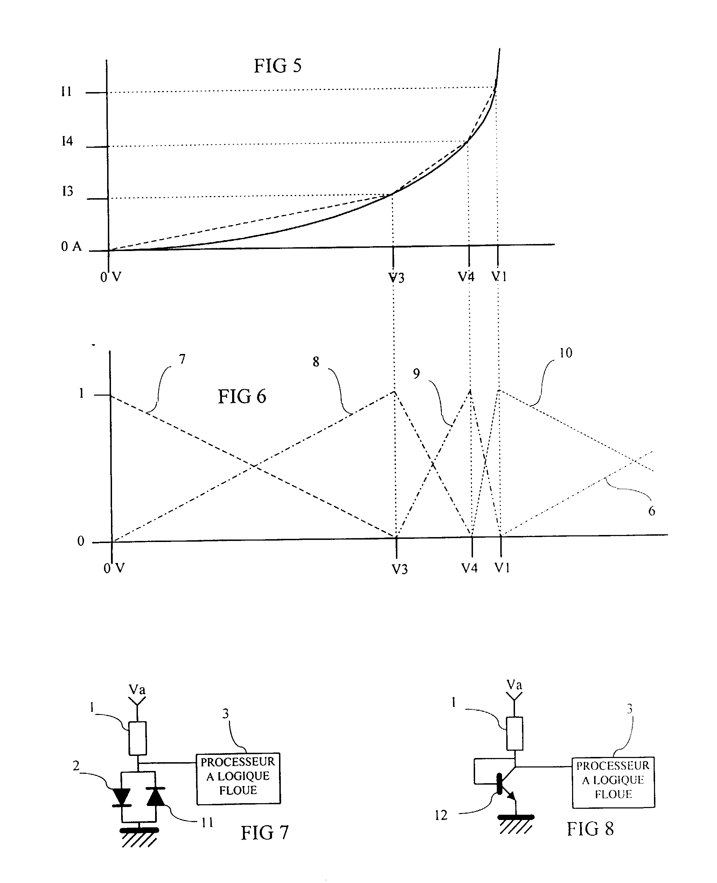

Sur la figure 5, on peut voir un grossissement de la caractéristique de la diode sur le troisième domaine. Ce grossissement permet de monter une approximation de la caractéristique sur le troisième domaine. Pour cela il a été rajouté des seuils de tension supplémentaires V3 et V4 auxquels correspondent respectivement les courants I3 et I4. Les fonctions d'appartenance associées à cette approximation de la caractéristique de la diode sont représentées sur la figure 6. Des trois fonctions d'appartenance précédemment définies, seul la troisième fonction d'appartenance 6 a été conservée. Les première et deuxième fonctions d'appartenance 4 et 5 sont remplacées par des quatrième, cinquième, sixième et septième fonctions d'appartenance 7 à 10.

La quatrième fonction d'appartenance 7 vaut "1" pour toutes les tensions inférieures ou égales à 0 V, décroît linéairement jusqu'à "0" pour une tension comprise entre 0 V et V3, et vaut "0" pour les tensions supérieures à V3. La cinquième fonction d'appartenance 8 vaut "0" pour les tensions inférieures à 0 V ou supérieures à V4, croit linéairement de "0" à "1" pour des tensions allant de 0 V à V3, et décroît linéairement de "1" à "0" pour des tensions allant de V3 à V4. La sixième fonction d'appartenance 9 vaut "0" pour les tensions inférieures à V3 ou supérieures à V1, croit linéairement de "0" à "1" pour des tensions allant de V3 à V4, et décroît linéairement de "1" à "0" pour des tensions allant de V4 à V1. La septième fonction d'appartenance 10 vaut "0" pour les tensions inférieures à V4 ou supérieures à V2, croit linéairement de "0" à "1" pour des tensions allant de V4 à V1, et décroît linéairement de "1" à "0" pour des tensions allant de V1 à V2.

Le processeur à logique floue dispose donc de cinq règles, une pour chaque fonction d'appartenance:
- si la tension mesurée appartient à la troisième fonction d'appartenance 6, alors le courant est égal à Imax,
- si la tension mesurée appartient à la quatrième fonction d'appartenance 7, alors le courant est égal à 0,
- si la tension mesurée appartient à la cinquième fonction d'appartenance 8, alors le courant est égal à I3,
- si la tension mesurée appartient à la sixième fonction d'appartenance 9, alors le courant est égal à I4,
- si la tension mesurée appartient à la septième fonction d'appartenance 10, alors le courant est égal à I1.

Les seuils V1, V2, V3 et V4 sont mémorisés par apprentissage.

On remarque qu'il est encore possible de rajouter d'autres fonctions d'appartenance pour obtenir une meilleure précision.

Dans la théorie de la logique floue, les fonctions d'appartenance peuvent avoir des formes relativement compliquées. Dans l'invention nous proposons des formes simples de type triangulaire qui sont très faciles à exploiter. En effet, il suffit de réaliser des opérations simples. Pour obtenir le pourcentage d'appartenance, il suffit de réaliser trois soustractions et une division. Ce qui revient à faire les opérations suivante: ( Vm - Vsb) / (Vsh - Vsb) pour un premier pourcentage et 1 - (Vm - Vsb) / (Vsm - Vsb) pour le deuxième pourcentage, Vm étant la tension mesurée, Vsb étant le seuil bas de la fonction d'appartenance et Vsm étant le seuil correspondant au maximum de la fonction d'appartenance. Les divisions étant des opérations qui demandent un temps assez important, on peut enregistrer lors de l'étalonnage les valeurs de 1 / (Vsh - Vsb) et remplacer la division par une multiplication.

Pour les autres modes de réalisation de l'invention qui vont suivre, l'homme de métier est capable de décomposer les différentes caractéristiques des composants suivant la précision qu'il désire à l'image des approximations de caractéristique de diode. Afin d'alléger la description, les décompositions des caractéristiques des composants ne seront pas détaillées.

Sur la figure 7, il a été rajouté une deuxième diode 11 montée en inverse parallèlement à la diode 2, cela permet de mesurer le courant dans les deux sens.

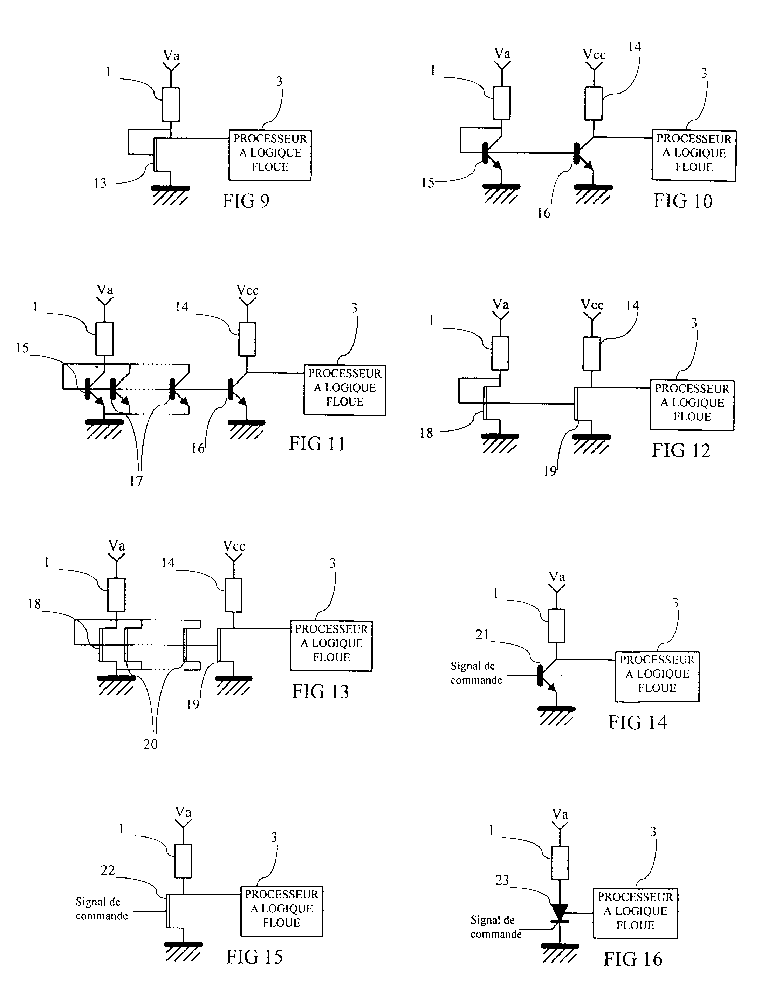

La diode 2 peut être remplacée par un transistor bipolaire 12 ou un transistor MOS 13 montés en diode comme on peut le voir sur les figures 8 et 9.

Les figures 8 et 9 peuvent être améliorées en utilisant un miroir de courant afin de découpler l'entrée du processeur flou de l'alimentation de puissance Va, si cette tension est trop élevée. Ainsi sur la figure 10 on utilise un montage dit miroir de courant. la deuxième borne de la charge 1 est reliée au collecteur d'un transistor 15 monté en diode, l'émetteur de ce transistor 15 étant relié à la masse. Une deuxième charge 14 a une première borne reliée à la tension d'alimentation Vcc du processeur flou 3, une deuxième borne de cette deuxième charge 14 étant reliée au collecteur d'un transistor 16. Le transistor 16 a sa base connectée à la base du transistor 15, l'émetteur du transistor 16 étant relié à la masse (la masse est commune aux deux alimentations). Le processeur à logique floue mesure la tension de collecteur du transistor 16. Un miroir de courant est constitué avec les deux transistors 15 et 16 si ces deux transistor sont rigoureusement identiques en dimensions (de préférence sur le même substrat).

Le dispositif à miroir de courant a comme désavantage de faire consommer dans la deuxième charge 14 un courant considérable. Il est possible de réduire cette consommation en ajoutant plusieurs transistors 17 montés en parallèle avec le transistor 15, tous ces transistors 15, 16 et 17 devant avoir les mêmes dimensions. Un tel montage est représenté sur la figure 11. Il serait préférable d'utiliser une matrice de transistors identiques utilisant un même substrat dont un des transistors servirait au prélèvement du courant. Un tel dispositif permet de diviser le courant dans la charge 14 par le nombre de transistors 15 et 17 utilisés. Il est également possible d'utiliser un transistor 15 plus gros que le transistor 16, mais la précision est moindre.

La transposition avec des transistors MOS se fait automatiquement en remplaçant les transistors 15, 16 et 17 par des transistors MOS 18, 19 et 20. Les figures 12 et 13 sont équivalentes aux figures 10 et 11.

Un autre intérêt de l'utilisation d'un élément non linéaire pour effectuer la mesure du courant est d'utiliser un composant servant à la commutation de la charge 1 pour effectuer la mesure. Ainsi sur la figure 14, on peut voir la charge 1 qui est commutée par un transistor 21 servant d'interrupteur entre une tension d'alimentation Va et la masse en fonction d'un signal de commande. La mesure de tension faite par le processeur à logique floue 3 peut être faite sur le collecteur du transistor 21 ou sur la base du transistor 21. Le choix du collecteur ou de la base comme point de mesure dépend en fait de l'importance du courant à mesurer. Si celui-ci est faible, les variations de tension sur la base ne sont pas suffisamment importantes pour mesurer le courant et il est donc préférable de faire la mesure sur le collecteur. Si l'on utilise un transistor MOS 22 comme sur la figure 15, la mesure de tension se fait évidement sur le drain.

Il est également possible d'utiliser un thyristor 23 comme on peut le voir sur la figure 16. La deuxième borne de la charge 1 est reliée à l'anode du thyristor 23, la cathode de ce thyristor 23 étant reliée à la masse. Un signal de commande est envoyé sur la gâchette du thyristor 23. La tension mesurée sera préférentiellement la tension de la jonction PN du thyristor 23 dont la zone dopée N est connectée à la masse.

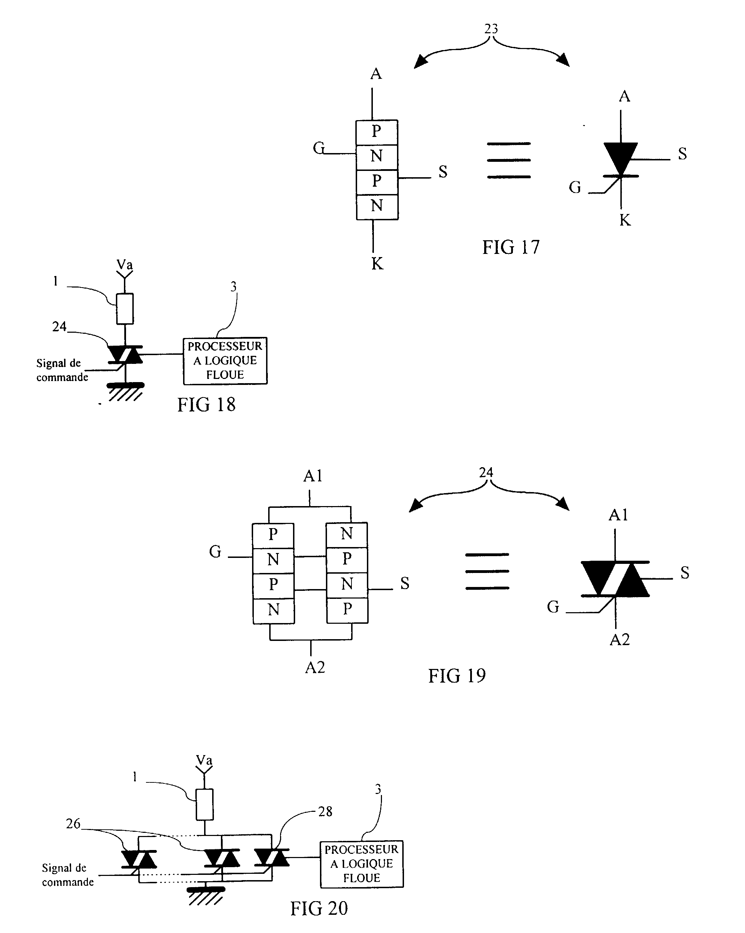

Sur la figure 17 est représenté le thyristor 23. A gauche, on peut voir une représentation schématique en coupe. Les quatres couches de dopage alterné N et P sont représentées par des rectangles. Classiquement, la couche P prise entre les deux couches N n'a pas de borne reliée à l'extérieur. On propose de réaliser une borne notée S afin de pouvoir prélever la tension entre S et la cathode notée K. Cela revient à faire une mesure au borne d'une diode. De plus, effectuer la mesure sur S permet de protéger l'entrée du processeur à logique floue 3 contre des tensions qui risquent d'être destructrices.

A l'image du thyristor 23, on peut également utiliser un triac 24 comme le montre la figure 18. Là encore, on va de préférence avoir recours à une sortie de mesure sur le triac 24. La figure 19 montre sur quelles couches semi-conductrices on effectue la mesure de tension représentative du courant. De plus, l'entrée du processeur à logique floue est complètement protégée car elle se trouve connectée à un montage à diode du type représenté figure 7.

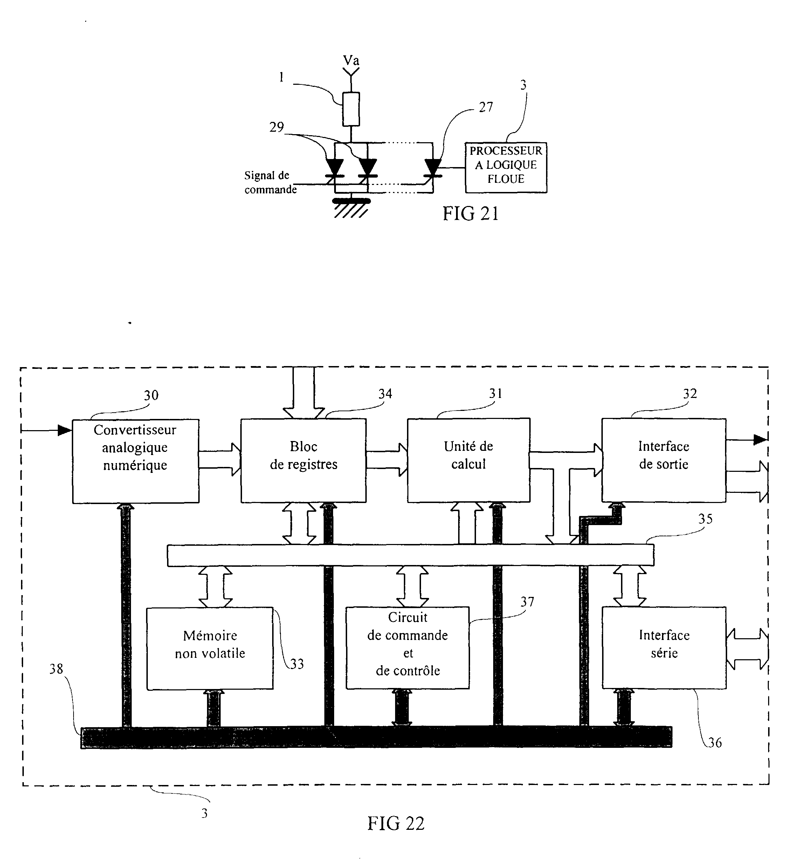

On peut également avoir recours à une matrice de triacs 26 ou de thyristors 27 comme le montrent les figures 20 et 21. On sait que si l'on utilise un seul triac 24 (ou thyristor 23) de grosse dimension pour commuter une charge traversée par un courant très important, il y a risque de destruction du triac 24 (ou thyristor 23) lors des différentes commutation. Le fait d'avoir recours à une matrice de triacs 26 (ou thyristor 27) de taille plus petite limite le risque de destruction par une répartition homogène du courant dans les différents triacs 26 (ou thyristor 27). L'invention propose de ne mesurer la tension de la borne S (représentée figures 17 et 19) que sur un seul élément 28 (ou 29). En effet, tous les triacs 26 et 28 (ou thyristors 27 et 29) situés sur une matrice de même substrat sont parcourus par le même courant. De plus, les thyristors 27 et 29 ou triacs 26 et 28 ont une température moins élevée dans une matrice, rendant la mesure moins dépendante de la température.

L'homme de métier comprend aisément que l'on peut utiliser d'autres éléments non linéaires pour effectuer la mesure (semi-conducteur ou non) sans pour autant sortir du cadre de l'invention. De plus de nombreuses variantes incluant des éléments de protection supplémentaires visant à éviter d'avoir des tensions destructrices sur l'entrée du processeur à logique floue sont possibles et ne sortent pas du cadre de l'invention.

En ce qui concerne le processeur à logique floue 3, on choisit préférentiellement un processeur du type représenté sur la figure 22. Ce processeur à logique floue dispose de:
- un convertisseur 30 analogique/numérique disposant d'au moins une entrée analogique reliée à une borne d'entrée du processeur 3, une sortie de donnée (par exemple sur 8 bits), des entrées/sortie de signaux de commande et de contrôle notamment pour gérer les débuts et fins de conversion, et l'échantillonnage,
- une unité de calcul 31 disposant de deux entrées de données et d'une sortie de données, des entrées/sorties de commande et de contrôle pour gérer différentes opérations telles que comparaison, soustraction, addition, multiplication et division, qui sont nécessaires pour les calculs de fonctions d'appartenances de type triangulaires,
- une interface de sortie 32, ayant une entrée de données reliée à la sortie de l'unité de calcul 31, une sortie de données analogique est une sortie de données numérique reliées toutes les deux à des bornes de sortie du processeur 3, et des entrées de signaux de commande destinés à déterminer l'état des sorties (par exemple: haute impédance, mémorisation de la données de sortie analogique, etc...),
- une mémoire non volatile 33 (par exemple de type EPROM) ayant une entrée/sortie de données et des entrées de commande, cette mémoire 33 servant à mémoriser les différents seuils des fonctions d'appartenance et également les différentes règles de décision,
- un bloc de registres de travail 34, permettant des lectures/écritures de registres simultanées, et disposant d'une entrée de données reliée à la sortie de données du convertisseur 30, d'une entrée de données reliée à une borne d'entrée de données numérique du processeur 3, d'une sortie de données reliée à la première entrée de donnée de l'unité de calcul 31, d'une entrée/sortie de donnée reliée à un bus de données 35, et d'entrées de commande (pour sélectionner le stockage ou l'extraction de données dans un ou plusieurs des registres à partir des différentes entrées/sorties du bloc de registres 34,
- le bus de données 35 relie l'entrée/sortie de données du bloc de registres 34, la deuxième entrée de l'unité de calcul 31, la sortie de l'unité de calcul 31 et l'entrée/sortie de données de la mémoire non volatile 33,
- une interface série 36 ayant une entrée/sortie série (selon un standard classiquement utilisé) reliée à une borne du processeur 3, une entrée sortie de données "parallèle" reliée au bus de données 35, des entrées/sorties de commande et de contrôle,
- un circuit de commande 37 et de contrôle ayant une entrée/sortie de données reliée au bus de données et des entrées/sorties de commande et de contrôle reliée à un bus de commande 38, ce circuit de commande 37 sert à séquencer toutes les opérations se produisant dans le processeur,
- le bus de commande relie toutes les entrées et entrées/sorties de commande et/ou de contrôle de tous les éléments du circuit avec les entrées/sorties de commande et de contrôle du circuit de commande 37.

Le circuit de commande 37 effectue un séquencement du processeur qui consiste à échantillonner et convertir les données entrant sur le convertisseur 30 ou entrant directement sur le bloc de registre, puis à faire défiler les différentes règles de décision en vérifiant à chaque fois l'appartenance aux fonctions d'appartenance correspondant à ces règles. Dans un fonctionnement normal, le circuit de commande 37 alterne donc une mise à jour des paramètres d'entrée et un balayage des règles. Bien évidement un résultat est donné à la fin du balayage des règles. Le circuit de commande va également s'occuper des transferts d'information avec l'extérieur via l'interface série qui permettent d'avoir des fonctionnements particuliers du processeur 3, notamment l'enregistrement des différents paramètres.

Un tel processeur à logique floue est déjà commercialisé par la société dite SGS-THOMSON MICROELECTRONICS sous le nom de W.A.R.P.3.

De plus, les processeurs à logique floue existant mettent à disposition des fonction d'appartenance de type trapèze ou de type gaussienne. Une amélioration de l'invention est de combiner l'approximation linéaire expliquée précédement avec des demi-gaussiennes. L'utilisation de gaussiennes permet de diminuer le nombre de fonctions d'appartenance nécessaires pour suivre une courbe sans augmenter l'erreur, cela revient à effectuer une interpolation gaussienne.

L'homme de métier comprend également que d'autres entrées du processeur à logique floue peuvent être utilisées pour d'autres paramètres. De plus, la décision du processeur flou peut être d'un autre type que la valeur du courant, par exemple un signal de commande pour commuter la charge.

Les erreurs de mesure dépendent en fait de la résolution du convertisseur analogique/numérique. La résolution est classiquement de 1 ou 1/2 bit de poids le plus faible ce qui rend l'erreur inférieure à 1/2ⁿ (n étant le nombre de bits sur lesquels s'effectuent l'échantillonnage) fois la déviation de tension maximale. L'approximation linéaire de la courbe intervient également dans le calcul de l'erreur. Il est toutefois possible d'avoir une erreur inférieure à 1% de la déviation maximale à mesurer en utilisant un convertisseur 8 bits.

A titre d'exemple, si l'invention est utilisée dans une commande de moteur, le processeur à logique floue peut avoir une entrée pour la mesure du courant, une entrée pour la consigne de vitesse, une entrée pour la vitesse réelle et déterminer, en fonction de règles et fonctions d'appartenance de ces trois entrées, une décision qui est la commande du transistor commutant le moteur.

## Revendications

1. Circuit de mesure du courant dans une charge (1), ledit circuit comportant un élément non linéaire (2, 11, 12, 13, 16, 19, 21, 22, 23, 24, 27 ou 28) de transformation de courant en une tension, caractérisé en ce qu'il comporte un processeur à logique floue (3) pour traiter une mesure de ladite tension et fournir une information représentative du courant.

2. Circuit selon la revendication 1, caractérisé en ce que l'élément non linéaire est un transistor de mesure (13 ou 22), de type MOSFET, ayant sa source connectée à la masse et son drain connectée à une entrée du processeur à logique floue (3) et à une borne de la charge (1).

3. Circuit selon la revendication 1, caractérisé en ce que l'élément de transformation est un transistor de mesure (19), de type MOSFET, ayant sa source connectée à la masse et son drain connectée à une entrée du processeur à logique floue (3) et à un circuit de polarisation (14), et en ce qu'un transistor intermédiaire (18) a son drain connecté à une borne de la charge, sa source connectée à la masse et sa grille connectée à la grille du transistor de mesure (19).

4. Circuit selon la revendication 3, caractérisée en ce que le transistor intermédiaire (18) est monté en parallèle avec une pluralité de transistors (20) dont les dimensions sont identiques au transistor intermédiaire.

5. Circuit selon l'une des revendications 3 ou 4, caractérisé en ce que le transistor de mesure (19) a ses dimensions identiques aux dimensions du transistor intermédiaire (18).

6. Circuit selon l'une des revendications 2 à 5, caractérisé en ce que le transistor (13, 18, 20) connecté à la charge a son drain connecté à sa grille.

7. Circuit selon l'une des revendications 2 à 5, caractérisé en ce que le transistor (22) connecté à la charge a sa grille reliée à un circuit de commande et en ce que ledit transistor (22) est utilisé comme interrupteur.

8. Circuit selon l'une des revendications 2 à 7, caractérisé en ce que les transistors MOSFET (13, 18, 19, 20, 22) sont remplacés par des transistors bipolaires (12, 15, 16, 17, 21).

9. Circuit selon la revendication 1, caractérisé en ce que l'élément de transformation est une diode (2).

10. Circuit selon la revendication 1, caractérisé en ce que l'élément de transformation est constitué de deux diodes (2, 11) montées parallèlement en sens inverse l'une de l'autre.

11. Circuit selon la revendication 1, caractérisé en ce que l'élément de transformation est un thyristor de mesure (23, 27) dont la gâchette est reliée à un signal de commande.

12. Circuit selon la revendication 11, caractérisé en ce que le thyristor de mesure (27) est monté en parallèle avec une pluralité de thyristors (29) de dimensions identiques.

13. Circuit selon la revendication 1, caractérisé en ce que l'élément de transformation de courant est un triac de mesure (24, 28) dont la gâchette est reliée à un signal de commande.

14. Circuit selon la revendication 13, caractérisé en ce que le triac de mesure (28) est monté en parallèle avec une pluralité de triacs (26) de dimensions identiques.

15. Circuit selon l'une des revendications 1 à 14, caractérisé en ce que le processeur à logique floue (3) comporte une zone mémoire non volatile (33), et en ce que des fonctions d'appartenance (4 à 10) et des règles de décision relative à l'information représentative du courant sont stockés dans la mémoire non volatile (33).

16. Circuit selon la revendication 15, caractérisé en ce que au moins une des fonctions d'appartenance (4 à 10) est de type triangulaire.

17. Circuit selon la revendication 16, caractérisé en ce que le processeur à logique floue (3) effectue une approximation linéaire d'une caractéristique de transfert courant-tension de l'élément non linéaire.

18. Circuit selon la revendication 15 caractérisé en ce que au moins une des fonctions d'appartenance est de type gaussienne.

19. Circuit selon l'une des revendications 15 à 18, caractérisé en ce que la mémoire non-volatile comporte des seuils de tensions (V1, V2, V3 et V4) pour délimiter les fonctions d'appartenance (4 à 10), les dits seuils (V1 à V4) étant mémorisés dans la mémoire non volatile (33) lors d'un étalonnage du circuit de mesure.

20. Circuit selon l'une des revendications 15 à 19, caractérisé en ce que les règles de décision déterminent une information représentative du courant dans la charge.

21. Circuit selon l'une des revendications 15 à 20, caractérisé en ce que le processeur à logique floue (3) possède plusieurs entrées d'information et en ce que les règles de décisions déterminent un signal de commande.

## Patentansprüche

1. Schaltkreis zum Messen des Stromes durch eine Last (1), wobei der Schaltkreis ein nicht-lineares Element (2, 11, 13, 16, 19, 21, 22, 23, 24, 27 oder 28) zur Transformation eines Strom in eine Spannung umfaßt,
dadurch **gekennzeichnet**, daß
er einen Prozessor für unscharfe Logik (3) zum Verarbeiten einer Messung der genannten Spannung und zum Ausgeben einer Information in Abhängigkeit von dem Strom umfaßt.

2. Schaltkreis nach Anspruch 1, dadurch **gekennzeichnet**, daß das nicht-lineare Element ein Meßtransistor (13 oder 22) vom Typ MOSFET ist, dessen Source mit Masse verbunden ist und dessen Drain mit einem Eingang des Prozessors für unscharfe Logik (3) und einem Anschluß für die Last (1) verbunden ist.

3. Schaltkreis nach Anspruch 1, dadurch **gekennzeichnet**, daß das Transformationselement ein Meßtransistor (19) vom Typ MOSFET ist, dessen Source mit Masse verbunden ist und dessen Drain mit einem Eingang des Prozessors für unscharfe Logik (3) und einem Vorspannungsschaltkreis (14) verbunden ist, und daß ein Zwischentransistor (18) über seinen Drain mit einem Anschluß für die Last, über seine Source mit der Masse und über sein Gate mit dem Gate des Meßtransistors (19) verbunden ist.

4. Schaltkreis nach Anspruch 3, dadurch **gekennzeichnet**, daß der Zwischentransistor (18) parallel geschaltet ist zu mehreren Transistoren (20), deren Dimensionen identisch sind zu dem Zwischentransistor.

5. Schaltkreis nach einem der Ansprüche 3 oder 4, dadurch **gekennzeichnet,** daß der Meßtransistor (19) die gleichen Dimensionen hat wie der Zwischentransistor (18).

6. Schaltkreis nach einem der Ansprüche 2 bis 5, dadurch **gekennzeichnet,** daß bei dem Transistor (13, 18, 20), der mit der Last verbunden ist, der Drain mit seinem Gate verbunden ist.

7. Schaltkreis nach einem der Ansprüche 2 bis 5, dadurch **gekennzeichnet**, daß bei dem Transistor (22), der mit der Last verbunden ist, das Gate mit einem Steuerschaltkreis verbunden ist und daß der genannte Transistor (22) als Unterbrecher genützt wird.

8. Schaltkreis nach einem der Ansprüche 2 bis 7, dadurch **gekennzeichnet**, daß die MOSFET-Transistoren (13, 18, 19, 20, 22) ersetzt werden durch Bipolar-transistoren (12, 15, 16, 17 21).

9. Schaltkreis nach Anspruch 1, dadurch **gekennzeichnet**, daß das Transformationselement eine Diode (2) ist.

10. Schaltkreis nach Anspruch 1, dadurch **gekennzeichnet,** daß das Transformationselement aus zwei Dioden (2, 11) besteht, die parallel in jeweils umgekehrter Polarität geschaltet sind.

11. Schaltkreis nach Anspruch 1, dadurch **gekennzeichnet**, daß das Transformationselement ein Meßthyristor (23, 27) ist, dessen Gate verbunden ist mit einem Steuersignal.

12. Schaltkreis nach Anspruch 11, dadurch **gekennzeichnet**, daß der Meßthyristcr (27) parallel zu mehreren thyristoren (29) mit identischen Dimensionen geschaltet ist.

13. Schaltkreis nach Anspruch 1, dadurch **gekennzeichnet,** daß das Transformationselement für den Strom ein Meßtriac (24, 28) ist, dessen Gate mit einem Steuersignal verbunden ist.

14. Schaltkreis nach Anspruch 13, dadurch **gekennzeichnet**, daß der Meßtriac (28) parallel zu mehreren Triacs (26) mit identischen Dimensionen geschaltet ist.

15. Schaltkreis nach einem der Ansprüche 1 bis 14, dadurch **gekennzeichnet**, daß der Prozessor für unscharfe Logik (3) einen nicht-flüchtigen Speicherbereich (33) umfaßt und Zugehörigkeitsfunktionen (4 bis 10) und Entscheidungsregeln für die Information, die von dem Strom abhängt, abglegt sind im nicht-flüchtigen Speicher (33).

16. Schaltkreis nach Anspruch 15, dadurch **gekennzeichnet**, daß wenigstens eine der Zugeförigkeitsfunktionen (4 bis 10) vom Dreieckstyp sind.

17. Schaltkreis nach Anspruch 16, dadurch **gekennzeichnet**, daß der Prozessor für unscharfe Logik (3) eine lineare Näherung einer Stromspannungsübertragungseigenschaft des nicht-linearen Elements durchführt.

18. Schaltkreis nach Anspruch 15, dadurch **gekennzeichnet**, daß wenigstens eine der Zugehörigkeitsfunktionen vom Gauß-Typ ist.

19. Schaltkreis nach einem der Ansprüche 15 bis 18, dadruch **gekennzeichnet**, daß der nicht-flüchtige Speicher Schwellenspannungen (V1, V2, V3 und V4) zum Begrenzen der Zugehörigkeitsfunktionen (4 bis 10) umfaßt, wobei die Schwellen (V1 bis V4) abgelegt werden in dem nicht-flüchtigen Speicher (33), wenn eine Eichung des Meßschaltkreises vorgenommen wird.

20. Schaltkreis nach einem der Ansprüche 15 bis 19, dadurch **gekennzeichnet**, daß die Entscheidungsregeln eine Information bestimmen, die von dem Strom durch die Last abhängt.

21. Schaltkreis nach einem der Ansprüche 15 bis 20, dadurch **gekennzeichnet**, daß der Prozessor für unscharfe Logik (3) mehrere Informationseingänge aufweist und daß die Entscheidungsregeln ein Steuersignal festlegen.

## Claims

1. Circuit for measuring the current in a load (1), the said circuit including a non-linear element (2, 11, 12, 13, 16, 19, 21, 22, 23, 24, 27 or 28) for transforming the current into a voltage, characterised in that it includes a fuzzy logic processor (3) for processing a measurement of the said voltage and supplying an item of information representing the current.

2. Circuit according to Claim 1, characterised in that the non-linear element is a measuring transistor (13 or 22), of the MOSFET type, having its source connected to earth and its drain connected to an input of the fuzzy logic processor (3) and to a terminal of the load (1).

3. Circuit according to Claim 1, characterised in that the transformation element is a measuring transistor (19), of the MOSFET type, having its source connected to earth and its drain connected to an input of the fuzzy logic processor (3) and to a biasing circuit (14), and in that an intermediate transistor (18) has its drain connected to a terminal of the load, its source connected to earth and its gate connected to the gate of the measuring transistor (19).

4. Circuit according to Claim 3, characterised in that the intermediate transistor (18) is connected in parallel with a plurality of transistors (20) whose dimensions are identical to the intermediate transistor.

5. Circuit according to one of Claims 3 or 4, characterised in that the dimensions of the measuring transistor (19) are identical to the dimensions of the intermediate transistor (18).

6. Circuit according to one of Claims 2 to 5, characterised in that the transistor (13, 18, 20) connected to the load has its drain connected to its gate.

7. Circuit according to one of Claims 2 to 5, characterised in that the transistor (22) connected to the load has its gate connected to a control circuit and in that the said transistor (22) is used as a switch.

8. Circuit according to one of Claims 2 to 7, characterised in that the MOSFET transistors (13, 18, 19, 20, 22) are replaced by bipolar transistors (12, 15, 16, 17, 21).

9. Circuit according to Claim 1, characterised in that the transformation element is a diode (2).

10. Circuit according to Claim 1, characterised in that the transformation element consists of two diodes (2, 11) connected in parallel in reverse orientations to each other.

11. Circuit according to Claim 1, characterised in that the transformation element is a measuring thyristor (23, 27) whose gate is connected to a control signal.

12. Circuit according to Claim 11, characterised in that the measuring thyristor (27) is connected in parallel with a plurality of thyristors (29) of identical dimensions.

13. Circuit according to Claim 1, characterised in that the current transformation element is a measuring triac (24, 28) whose gate is connected to a control signal.

14. Circuit according to Claim 13, characterised in that the measuring triac (28) is connected in parallel with a plurality of triacs (26) of identical dimensions.

15. Circuit according to one of Claims 1 to 14, characterised in that the fuzzy logic processor (3) has a non-volatile memory area (33), and in that membership functions (4 to 10) and decision rules relating to the information representing the current are stored in the non-volatile memory (33).

16. Circuit according to Claim 15, characterised in that at least one of the membership functions (4 to 10) is of the triangular type.

17. Circuit according to Claim 16, characterised in that the fuzzy logic processor (3) effects a linear approximation of a current-voltage transfer characteristic of the non-linear element.

18. Circuit according to Claim 15, characterised in that at least one of the membership functions is of the Gaussian type.

19. Circuit according to one of Claims 15 to 18,
characterised in that the non-volatile memory has voltage thresholds (V1, V2, V3 and V4) for delimiting the membership functions (4 to 10), the said thresholds (V1 to V4) being stored in the non-volatile memory (33) when the measuring circuit is calibrated.

20. Circuit according to one of Claims 15 to 19,
characterised in that the decision rules determine an item of information representing the current in the load.

21. Circuit according to one of Claims 15 to 20,
characterised in that the fuzzy logic processor (3) has several information inputs and in that the decision rules determine a control signal.
